# EUROPÄISCHE PATENTANMELDUNG

(11) **EP 3 786 649 A1**
(43) Veröffentlichungstag der Anmeldung: **03.03.2021**
(21) Anmeldenummer: 19194259.8
(22) Anmeldetag: 29.08.2019
(51) Int. Cl.: G01R 19/165

(54) **VERFAHREN ZUM ÜBERPRÜFEN VON LASTKREISEN IN EINER TECHNISCHEN ANLAGE**

(71) Anmelder: Siemens Aktiengesellschaft, 80333 München (DE)
(72) Erfinder: Schweigert, Harald, 1120 Wien (AT)
(74) Vertreter: Maier, Daniel Oliver

(57) **Zusammenfassung**

Die Erfindung betrifft ein Verfahren zum Überprüfen von Lastkreisen eines Steuersystems in einer Anlage, welches zumindest zwei Lastkreise mit zumindest einer Lasteinheit, eine Steuereinheit (SE) und eine getaktete Stromversorgung (SV) umfasst. Die Stromversorgung (SV) versorgt über zumindest zwei Ausgangskanäle (A1 bis A8) die zumindest zwei Lastkreise mit einer Versorgungsspannung bzw. einem Versorgungsstrom. Die Ausgangskanäle (A1 bis A8) werden durch Steuersignale der Steuereinheit (SE) angesteuert. Erst werden Referenzwerte für Strom oder Spannung für jeweils vorgegebene Anlagenzustände ermittelt (101), wobei bei einem vorgegebenen Anlagenzustand zumindest ein Ausgangskanal (A1 bis A8) eingeschaltet und der jeweils zugehörige Lastkreis mit vorgegebenen Spannungswerten der Versorgungsspannung oder vorgegebenen Stromwerten des Versorgungsstroms versorgt wird. Die für die vorgegebenen Anlagenzustände ermittelten Referenzwerte werden abgespeichert (102). Dann werden während einer Selbsttestphase für die jeweils vorgegebenen Anlagenzustände aktuelle Strom- oder Spannungswerten an dem zumindest einen eingeschalteten Ausgangskanal (A1 bis A8) bei den jeweils vorgegebenen Spannungswerten der Versorgungsspannung oder bei den jeweils vorgegebenen Stromwerten des Versorgungsstroms gemessen (103) und geprüft (104), ob bei einem der vorgegebenen Anlagenzustände ein vorgegebener Toleranzbereich bei einem Vergleich der jeweils aktuell gemessenen Werte mit den jeweils entsprechenden, abgespeicherten Referenzwerten verlassen wird. Wird der Toleranzbereichs bei einem Anlagenzustand verlassen, so wird der entsprechende, zugehörige Lastkreis angezeigt (105).

## Beschreibung

### Technisches Gebiet

Die gegenständliche Erfindung betrifft allgemein das Gebiet der Elektrotechnik, insbesondere den Bereich der Leistungselektronik sowie leistungselektronischer Schaltungen. Im Speziellen bezieht sich die vorliegende Erfindung auf ein Verfahren zum Überprüfen von Lastkreisen eines Steuersystems in einer technischen Anlage. Dieses Steuersystem umfasst neben zumindest zwei Lastkreisen zumindest eine Steuereinheit sowie eine getaktete Stromversorgung. Von der getakteten Stromversorgung werden die zumindest zwei Lastkreise, welche jeweils zumindest eine Lasteinheit (z.B. Sensor, Aktor, Relais, Schütz, Magnetventil, Stellmotor, etc.) aufweisen, mit einer Versorgungsspannung und/oder einem Versorgungsstrom versorgt. Dazu sind die zumindest zwei Lastkreise an zumindest zwei Ausgangskanäle angebunden, welche entweder durch zumindest zwei direkte Ausgänge der Stromversorgung oder durch zwei extern angeschaltete, getrennt schaltbare Ausgangszweige gebildet werden. Für eine Ansteuerung der zumindest zwei Ausgangskanäle werden von der Steuereinheit Steuersignale zur Verfügung gestellt.

### Stand der Technik

Heutzutage kommen in vielen Bereichen, wie z.B. in der industriellen Produktion und Fertigung, in der Energieerzeugung und -verteilung, in der Automatisierungstechnik, im Gebäudemanagement, etc., komplexe Maschinen und/oder Anlagen zum Einsatz. Als Anlage wird dabei eine planvolle Zusammenstellung von in räumlichen Zusammenhang stehenden und funktional, steuerungstechnisch und/oder sicherheitstechnisch miteinander verknüpften Komponenten (z.B. Maschinen, Geräten und/oder Apparaten) verstanden. Derartige technische Anlagen, wie beispielsweise Produktionsanlagen, Fertigungsanlage, Energieerzeugungs- und Energieverteilungsanlagen, etc., bzw. deren Komponenten weisen eine zunehmende Komplexität auf. Für einen effizienten Betrieb von technischen Anlagen und komplexen Maschinen werden daher üblicherweise Steuerungssysteme eingesetzt, bei welchem von Sensor- oder Messeinheiten Betriebs- oder Prozessparameterwerte der Anlage oder Maschine gemessen werden und in Abhängigkeit von den gemessenen Betriebs- oder Prozessparameterwerten Aktoreinheiten oder Lasteinheiten (z.B. Schütze, Magnetventile, optische oder akustische Warnsignale, Motoreinheiten, Anzeigeeinheiten, etc.) angesteuert werden, um z.B. Betriebs- oder Prozessparameter zu verändern. Durch das Steuersystem soll der Betrieb der Maschine bzw. Anlage möglichst selbständig und unabhängig von menschlichen Eingriffen erfolgen.

Für die Auswertung der Messwerte von den Sensor- oder Messeinheiten und zum Ansteuern der Aktoreinheiten (z.B. Stellmotor, Warnsignal, Anzeigeeinheit, etc.) weist das Steuersystem üblicherweise eine Steuereinheit auf. Mit Hilfe der Steuereinheit können weiterhin beispielsweise nach prozesstechnischen Erfordernissen verschiedene Lasteinheiten, wie z.B. Schütze, Magnetventile, welches mittels eines Elektromagneten betätigt wird, etc., zu- oder weggeschaltet werden. Als Steuereinheit kann beispielsweise eine so genannte speicherprogrammierbare Steuerung oder SPS, ein Mikrocontroller oder ein Industrie-PC eingesetzt werden.

Weiterhin weist ein derartiges Steuersystem zumindest eine getaktete Stromversorgung (wie z.B. ein Schaltnetzteil) auf, durch welche eine unstabilisierte Eingangsspannung - meist eine Wechselspannung - in eine konstante Ausgangsspannung - meist eine Gleichspannung (z.B. 24 Volt) - zur Versorgung der Lasteinheiten des Steuersystems umgewandelt wird. Eine derartige Stromversorgung - wie z.B. die SITOP PSU8600 der Firma Siemens - kann beispielsweise zumindest zwei oder mehrere Ausgänge zum direkten Anschließen von Lastkreisen aufweisen, wobei diese Ausgänge als Ausgangskanäle genutzt werden und mittels Steuersignalen der Steuereinheit ansteuerbar sind. Alternativ kann eine getaktete Stromversorgung eingesetzt werden, an welche beispielsweise über einen Ausgang der Stromversorgung eine Baugruppe (z.B. schaltbare Sicherungseinheit, etc.) anschaltbar ist. Von dieser Baugruppe werden dann z.B. zumindest zwei getrennt schaltbare Ausgangszweige als Ausgangskanäle zur Verfügung gestellt werden. An jeden der Ausgangskanäle kann ein Lastkreis mit zumindest einer Last bzw. Lasteinheit oder mit einer Gruppe von Lasteinheiten angeschlossen werden. Die Last bzw. der Lastkreis wird dann über den jeweiligen Ausgangskanal mit einer Versorgungsspannung (z.B. 24 Volt) und/oder einem Versorgungsstrom versorgt, welche von der Stromversorgung zur Verfügung gestellt wird. Für eine Ansteuerung der Ausgangskanäle - d.h. für ein Ein- bzw. Ausschalten der Spannungs- und/oder Stromversorgung eines Lastkreises - können von der Steuereinheit Steuersignale z.B. der Stromversorgung zur Verfügung gestellt werden bzw. kann die Steuereinheit die Ausgangskanäle ansteuern sowie die Versorgungsspannung oder den Versorgungsstrom in den Ausgangskanäle (d.h. die Versorgungsspannung oder den Versorgungsstrom für den jeweils angeschlossenen Lastkreis) beeinflussen.

Bei der Stromversorgung mit zumindest zwei Ausgangskanälen kann beispielsweise Spannung und Strom für jeden Ausgangskanal individuell eingestellt und überwacht werden. So kann z.B. bei jedem Ausgangskanal der jeweilige Versorgungs- bzw. Laststrom oder alternativ auch die Spannung für den jeweils angeschlossenen Lastkreis gemessen und überwacht werden. Damit kann beispielsweise ein Stromverbrauch im jeweiligen Lastkreis oder einen aktuelle Spannung ermittelt werden, wobei sich durch Steuer- und Schalthandlungen der Steuereinheit des Steuersystems der Stromverbrauch oder die Spannung im jeweiligen Lastkreis verändern kann. D.h. durch eine Zu- und Wegschalten von Lasteinheiten (wie z.B. Schützen oder Magnetventilen, etc.) nach prozesstechnischen Erfordernissen in der Anlage oder Maschine kann sich der jeweilige Stromverbrauch im jeweiligen Lastkreis verändern.

Nach einem Aufstellen, Erweitern, etc. bzw. bei einer Inbetriebnahme einer komplexen Maschine oder Anlage stellt eine Überprüfung auf Fehler einen wesentlichen Aspekt dar, um einen reibungslosen und sicheren Betrieb zu gewährleisten. Insbesondere ist es wichtig, so genannte Verdrahtungsfehler in der Anlage bzw. im Steuersystem der Anlage - d.h. Fehler beim Anschließen einer oder mehrerer Lasteinheiten an einen Lastkreis bzw. einen Ausgangskanal der Stromversorgung - rechtzeitig zu erkennen, um einen ordnungsgemäßen Abläufe in der Anlage bzw. Maschine zu ermöglichen und Lasteinheiten, vor allem Sensor- und/oder Aktoreinheiten vor Beschädigung bzw. Zerstörung zu schützen.

Ein bisher übliche Methode zur Überprüfung einer Verdrahtung stellt beispielsweise das so genannte "Durchklingeln" oder "Durchpfeifen" mit Hilfe eines Durchgangsprüfers vor der Inbetriebnahme einer Anlage oder in einer Testphase dar. Ein Durchgangsprüfer ist ein elektrisches Prüfgerät, welches durch ein optisches oder akustisches Signal anzeigt, ob eine elektrische Verbindung zweier Punkte vorliegt. Mit einem Durchgangsprüfer können beispielsweise die einzelnen Verbindungen zwischen einem Ausgangskanal der Stromversorgung und einer Lasteinheit in einem Lastkreis des Steuersystems der Maschine bzw. Anlage - meist manuell - auf eine korrekte Verdrahtung überprüft werden. Diese Methode ist allerdings nicht sehr zeitaufwendig, sondern insbesondere bei komplexen Maschinen und/oder Anlagen mit mehreren Steuersystem-Lastkreisen auch fehleranfällig.

Eine weitere Überprüfungsmöglichkeit, ob die Verdrahtung des Steuersystems einer Anlage bzw. Maschine korrekt durchgeführt wurde, bieten z.B. automatisierte Verbindungstester, welche beispielsweise über Prüfkämme an Reihenklemmen in einem Schaltschrank der Anlage bzw. des Steuersystems kontaktiert werden und dann laut Schaltplan der Anlage vorgegebene Überprüfungen der Verbindungen vornehmen. Ein derartiger Verbindungstester ist allerdings eher kostspielig in der Anschaffung und erfordert z.B. ein eigenes Prüfprogramm, welches auf die Anlage oder Maschine abgestimmt sein muss. Insbesondere das jeweilige Prüfprogramm für den Verbindungstester kann z.B. bei Erweiterung, Umänderungen, etc. der Anlage oder Maschine kaum wiederverwendet werden oder muss aufwendig angepasst werden. Weiterhin werden von einem Verbindungstester zwar die Verbindungen in der Anlage geprüft, aber nicht die Funktionen der angeschlossenen Anlagekomponenten.

Es besteht beispielsweise aber auch die Möglichkeit, Verdrahtungsfehler erst bei oder während der Inbetriebnahme einer Anlage oder Maschine aufzuspüren. Bei der Inbetriebnahme einer Anlage oder Maschine kann z.B. ein Lastkreis des Steuersystems nach dem anderen aktiviert werden und die Funktion der jeweils über den Lastkreis angeschlossenen Lasteinheiten überprüft werden. Allerdings erfolgt diese Überprüfung bereits bei einer betriebsmäßigen Versorgungsspannung im jeweiligen Lastkreis, wobei der jeweilige Lastkreis meist auch nur betriebsmäßig abgesichert ist. Dadurch kann es bei einer gegebenenfalls vorliegenden Fehlverdrahtung angeschlossener Lasteinheiten, wie z.B. Sensor- oder Aktoreinheiten, zur Beschädigung oder Zerstörung dieser Einheiten kommen. Weiterhin ist es auf diese Weise sehr mühsam, die Richtigkeit von in der Anlage bzw. im Steuersystem der Anlage eingesetzten Lasteinheiten z.B. bei falschen Signalen oder Anlagenfehlfunktionen zu erkennen. D.h. wenn z.B. ein falscher Näherungsschaltertyp eingebaut wurde oder z.B. ein Sensor einem falschen Lastkreis zugeordnet worden ist.

Weiterhin ist z.B. mit dem REX-System der Firma E-T-A Elektrotechnische Apparate GmbH ein modular aufgebautes Stromverteilungs- und Sicherungssystem für eine zentrale Überwachung von dezentral aufgebauten Anlagen bekannt. Diese System umfasst zumindest ein Einspeisemodul zur Anbindung an eine getaktete Stromversorgung sowie zumindest ein Sicherungsmodul mit einem oder zwei Kanälen zur Anbindung und Absicherung eines Lastkreises. Über das Einspeisemodul können beispielsweise dynamische Anlageninformationen und Messwerte (z.B. aktuelle Spannungs- und Stromwerte in Lastkreisen, welche über ein oder mehrere Sicherungsmodulen angeschlossen sind, Auslösegrund eines Sicherungsmoduls, etc.) ermittelt und über eine Datenverbindung von einer übergeordnete Steuereinheit ausgelesen werden. Weiterhin kann z.B. bei den Sicherungsmodulen ein Nennstrom sowie ein Grenzwert für einen jeweiligen Stromwert im Lastkreis eingestellt werden. Damit können mit Hilfe dieses Stromverteilungs- und Sicherungssystems zwar extreme Defekte wie z.B. Kurzschlüsse in der Verdrahtung eines Lastkreises, Kurzschlüsse oder Überströme in einem Lastkreis - vor allem im laufende Betrieb einer Anlage festgestellt werden, aber ein Verdrahtungsfehler, welcher zu lediglich geringen Überströmen oder Stromabsenkungen gegenüber einem Sollzustand führen kann, sowie ein Einsatz einer falschen Lasteinheit in einem Lastkreis (z.B. nicht korrekter Näherungsschaltertyp, inkorrekt zugeordneter Sensor oder Aktor, auf der Versorgungs- und/oder Signalseite, etc.) sind ohne gezielte aufwendige manuelle Fehlersuche bzw. Datenanalyse durch einen Benutzer nur sehr schwer bis kaum erkennbar. Weiterhin wird durch das zumindest eine Sicherungsmodul der Bereich der Versorgungsspannung im Lastkreis auf einen typischen Betriebsspannungsbereich der jeweiligen Komponenten eingeschränkt, da das Sicherungsmodul z.B. aufgrund einer Betriebsspannungsüberwachung erst ab einer Betriebsspannung von ca. 16 Volt einschaltbar ist. Das System kann außerdem aufgrund des modularen Aufbaus zu erhöhten Aufwand und Kosten z.B. bei Anlagenplanung und Wartung führen.

### Darstellung der Erfindung

Der Erfindung liegt daher die Aufgabe zugrunde, ein Verfahren zum Überprüfen von Lastkreisen einer Anlage bzw. eines Steuersystems einer Anlage anzugeben, durch welches auf einfache Weise und ohne Einsatz zusätzlicher Testgeräte bzw. aufwendiger manueller Suche Verdrahtungsfehler und/oder ein Einsatz einer falschen Lasteinheit in einem Lastkreis der Anlage oder eine falsch zugeordnete Signaleinheit erkannt wird.

Diese Aufgabe wird durch ein Verfahren der eingangs genannten Art mit den Merkmalen gemäß dem unabhängigen Patentanspruch gelöst. Vorteilhafte Ausführungsformen der vorliegenden Erfindung sind in den abhängigen Ansprüchen beschrieben.

Erfindungsgemäß erfolgt die Lösung der Aufgabe durch ein Verfahren zum Überprüfen von Lastkreisen eines Steuersystems einer Anlage der eingangs angeführten Art, wobei das Steuersystem neben zumindest zwei Lastkreisen, welche jeweils zumindest eine Lasteinheit bzw. ein Verbraucher (z.B. Schütz, Magnetventil, Sensoreinheit, Aktoreinheit, etc.) aufweisen, zumindest eine Steuereinheit sowie eine getaktete Stromversorgung umfasst. Von der getakteten Stromversorgung werden die zumindest zwei Lastkreise mit jeweils zumindest einer Lasteinheit über zumindest zwei Ausgangskanäle mit einer Versorgungsspannung und/oder einem Versorgungsstrom versorgt, wobei die zumindest zwei Ausgangskanäle von zumindest zwei direkte Ausgänge der Stromversorgung oder von zumindest zwei Ausgangszweige einer an die Stromversorgung angeschalteten Baugruppe gebildet werden können. Weiterhin werden die Ausgangskanäle mittels Steuersignalen der Steuereinheit angesteuert. Dabei umfasst das erfindungsgemäße Verfahren zumindest die folgenden Schritte:
- Ermitteln von Referenzstromwerten bei vorgegebenen Spannungswerten der Versorgungsspannung oder Referenzspannungswerten bei vorgegebenen Stromwerten des Versorgungsstroms für jeweils vorgegebene Anlagenzustände, wobei bei einem vorgegebenen Anlagenzustand zumindest ein Ausgangskanal eingeschaltet wird und der jeweils zugehörige Lastkreis des Steuersystems von der Versorgungsspannung mit den vorgegebenen Spannungswerten oder vom Versorgungsstrom mit den vorgegebenen Stromwerten versorgt wird;
- Abspeichern der für die vorgegebenen Anlagenzustände ermittelten Referenzstromwerte oder der für die vorgegebenen Anlagenzustände ermittelten Referenzspannungswerte;
- Messen aktueller Stromwerten bei den jeweils vorgegebenen Spannungswerten der Versorgungsspannung oder aktueller Spannungswerte bei den jeweils vorgegebenen Stromwerten des Versorgungsstroms an dem zumindest einen eingeschalteten Ausgangskanal für den jeweils aktuell vorgegebenen Anlagenzustand während einer Selbsttestphase;
- Prüfen, ob bei einem der vorgegebenen Anlagenzustände ein vorgegebener Toleranzbereich bei einem Vergleich der jeweils aktuell gemessenen Stromwerte mit den jeweils entsprechenden, abgespeicherten Referenzstromwerten bei zumindest einem der vorgegebenen Spannungswert der Versorgungsspannung oder bei einem Vergleich der jeweils aktuell gemessenen Spannungswerte mit den jeweils entsprechenden, abgespeicherten Referenzspannungswerten bei zumindest einem der vorgegebenen Stromwerte des Versorgungsstrom verlassen wird;
- und Anzeigen des zugehörigen Lastkreises, wenn bei einem der vorgegebenen Anlagenzustände ein Verlassen des vorgegebenen Toleranzbereichs bei zumindest einem der vorgegebenen Spannungswerte der Versorgungsspannung oder bei zumindest einem der vorgegebenen Stromwerte des Versorgungsstroms festgestellt wird.

Der Hauptaspekt der erfindungsgemäß vorgeschlagenen Lösung besteht darin, dass damit die Möglichkeit besteht, auf einfache Weise und ohne Einsatz einer Testeinrichtung (z.B. Durchgangsprüfer, Verbindungstester, etc.) sehr genaue Detailmessungen in Lastkreisen einer Anlage oder einer komplexen Maschine bzw. zur Anlage oder Maschine gehörenden Steuerungssystems und eine Bewertung der Verdrahtung und der Korrektheit der an den jeweiligen Lastkreis angeschlossenen Lasteinheiten durchzuführen. Eine Auffindung von sozusagen versteckten Verdrahtungsfehlern wird durch das erfindungsgemäße Verfahren auf einfache Weise und ohne manuelle Suche oder detaillierte Datenanalyse durch z.B. einen Benutzer erleichtert und vereinfacht.

Ein Fehler in der Verdrahtung des Steuersystems der Anlage bzw. Maschine kann im entsprechenden Lastkreis zu einem betragsmäßig veränderten Stromverbrauch und damit Laststrom oder bei einem vorgegebenen bzw. eingeprägten Strom zu Spannungsveränderungen führen. Ebenso kann es zu Auswirkungen in jenem Lastkreis kommen, an welchen eine Lasteinheit z.B. fälschlicherweise angeschlossen wurde. Es kann beispielsweise bei einer falsch verdrahten Lasteinheit (z.B. Sensor, Aktor, etc.) zu einem gegenüber den ermittelten Referenzstromwerten geringeren Stromverbrauch im schaltplanmäßig zugeordneten Lastkreis und zu einem gegenüber den ermittelten Referenzstromwerten erhöhten Stromverbrauch in jenem Lastkreis kommen, an welchen die Lasteinheit fälschlicherweise angeschlossen wurde.

Bei dem erfindungsgemäßen Verfahren werden während einer Selbsttestphase bzw. während eines Testbetriebs der Anlage oder Maschine vorgegebene Anlagenzustände hervorgerufen. Für diese Anlagenzustände wurden Referenzstromwerte oder Referenzspannungswerte bestimmt und als Vergleichswerte abgespeichert. Ein Anlagenzustand beschreibt einen Betriebszustand der Anlage oder Maschine und kann z.B. über die Steuereinheit durch entsprechendes Ansteuern - d.h. Ein- und Ausschalten - der Ausgangskanäle - hervorgerufen werden. D.h. bei einem vorgegebenen Anlagenzustand ist zumindest ein Lastkreis aktiviert. Die zumindest eine zugehörige Lasteinheit des Lastkreises wird durch die Stromversorgung über den jeweiligen Ausgangskanal mit einer Versorgungsspannung bzw. einem Versorgungsstrom versorgt, wobei die Versorgungsspannung vorgegebene Spannungswerte annimmt oder der Versorgungsstrom eingeprägt werden kann. Dann wird am zumindest einen im aktuell vorgegebenen Anlagenzustand eingeschalteten Ausgangskanal für jeden der vorgegebenen Spannungswerte der Versorgungsspannung ein aktueller Stromwert des Laststroms im jeweils zugehörigen Lastkreis gezielt gemessen. Durch einen Vergleich der aktuell gemessenen Stromwerte des jeweiligen Anlagenzustands mit den entsprechenden Referenzstromwerten können Rückschlüsse über eine ordnungsgemäße Verdrahtung des Lastkreises bzw. der zumindest einen Lasteinheit und gegebenenfalls über eine ordnungs- bzw. planmäßige Funktionsfähigkeit der zumindest einen Lasteinheit gezogen werden. Alternativ kann am zumindest einen im aktuell vorgegebenen Anlagenzustand eingeschalteten Ausgangskanal ein aktueller Spannungswert für jeden der vorgegebenen bzw. eingeprägten Stromwerte des Versorgungsstroms im entsprechenden Lastkreis gezielt bestimmt werden. Dabei werden dann die aktuell gemessenen Spannungswerte des jeweiligen Anlagenzustands mit den entsprechenden Referenzspannungswerten beim jeweils vorgegebenen, eingeprägten Stromwerte des Versorgungsstroms verglichen und aus diesem Vergleich auf die Verdrahtung des jeweiligen Lastkreises rückgeschlossen. Eine z.B. fehlerhafte Verdrahtung des Lastkreises und/oder eine nicht korrekt eingesetzte bzw. verbaute Lasteinheit kann damit sehr einfach, rasch und gegebenfalls automatisiert - wenn z.B. vorgegebene Anlagenzustände in Form eines Testprogramms durchlaufen werden - erkannt werden.

Als zweckmäßige Weiterbildung des erfindungsgemäßen Verfahrens ist vorgesehen, dass für die jeweils vorgegebenen Anlagenzustände weiterhin Referenzspannungswerte für jene Ausgangskanäle und damit für jene Lastkreise ermittelt und abgespeichert werden, welche im jeweils vorgegebenen Anlagenzustand aus- bzw. weggeschaltet sind. Weiterhin werden während der Selbsttestphase aktuelle Spannungswerte für die im jeweils aktuellen Anlagenzustand ausgeschalteten Ausgangskanäle bzw. weggeschalteten Lastkreise gemessen und dann mit den für den jeweiligen Anlagenzustand entsprechenden Referenzspannungswerten verglichen. Wird beim Vergleich zwischen gemessenen Spannungswerten und korrespondierenden Referenzspannungswerten für den jeweiligen Anlagenzustand ein vorgegebener Toleranzbereich verlassen, so wird der entsprechende Lastkreis angezeigt. Durch das Messen einer Spannung an einem aus- bzw. weggeschalteten Lastkreis kann ebenfalls auf einfache Weise eine Korrektheit der Verdrahtung der Anlage bzw. Maschine bzw. des zugehörigen Steuersystems beurteilt und geprüft werden. So können beispielsweise an ausgeschalteten Ausgangskanälen bzw. Ausgangszweigen eines vorgegebenen Anlagenzustands gemessene Spannungswerte einen Hinweis auf eine fehlerhafte Verdrahtung im entsprechenden Lastkreis sein.

Zusätzlich kann es sinnvoll sein, dass auch für jeweils vorgegebene Anlagenzustände Referenzstromwerte für zumindest jene Ausgangskanäle ermittelt und abgespeichert werden, welche im jeweils vorgegebenen Anlagenzustand ausgeschaltet sind. Während der Selbsttestphase werden dann aktuelle Stromwerte für jene Ausgangskanäle gemessen werden, welche im jeweiligen Anlagenzustand ausgeschaltet sind, und mit den entsprechenden Referenzwerten verglichen. Der jeweilige Lastkreis wird dann angezeigt, bei welchem ein vorgegebener Toleranzbereich beim Vergleich zwischen gemessenen Stromwerten und jeweils entsprechenden, abgespeicherte Referenzstromwerten verlassen wird. Auch ein Stromfluss in einem im jeweiligen Anlagenzustand ausgeschalteten Lastkreis kann zusätzlich zum Erkennen einer Fehlverdrahtung bzw. zum Beurteilen einer ordnungsgemäßen Funktion der jeweiligen Lastkreises bzw. des Steuersystems der Anlage bzw. Maschine herangezogen werden.

Die Referenzstromwerte und die Referenzspannungswerte für die jeweiligen Anlagenzustände können idealerweise z.B. während einer Planungs- und Entwicklungsphase der Anlage oder Maschine mittels einer Referenzanlage z.B. beim Hersteller ermittelt werden. Damit stehen dann z.B. bei der Inbetriebnahme von Anlagen oder Maschinen desselben Typs (z.B. Serienanlage/-maschine) am jeweiligen Einsatzort Referenzstromwerte und gegebenenfalls Referenzspannungswerte zur Verfügung, welche für eine Überprüfung, ob die Lastkreise korrekt verdrahtet wurden und ob die richtigen Lasteinheiten an den jeweils geplanten Stellen bzw. in den geplanten Lastkreisen verbaut wurden, herangezogen werden können.

Alternativ oder zusätzlich, können die Referenzstromwerte und die Referenzspannungswerte für die jeweiligen Anlagenzustände während einer Inbetriebnahmephase der zu überprüfenden Anlage (z.B. bei einer Testinbetriebnahme beim Hersteller, etc.) ermittelt werden oder aus Stromwerten und Spannungswerten abgeleitet werden, welche z.B. während eines laufenden Betriebs der Anlage oder Maschine laufend für unterschiedliche Anlagenzustände an den jeweiligen Ausgangskanälen gemessen werden. D.h., die Referenzwerte werden idealerweise aus früheren Messwerten abgeleitet, welche bei verschiedenen Anlagenzuständen (z.B. im laufenden Betrieb, bei einer Inbetriebnahme beim Hersteller oder beim Benutzer) gemessen wurden. Das ist insbesondere sinnvoll, wenn eine Anlage oder Maschine beispielsweise teilweise zerlegt, transportiert und wiederaufgestellt wird. Bei einer Wiederinbetriebnahme bzw. beim Wiedereinschalten kann dann einen korrekte Verdrahtung der Lastkreise des Anlagen- bzw. Maschinen-Steuersystems bzw. eine ordnungsgemäße Funktion der Lastkreise sehr einfach überprüft werden.

Ein weitere zweckmäßige Fortbildung des erfindungsgemäßen Verfahrens sieht vor, dass für jeweils vorgegebene Anlagenzustände Referenzwerte von Parametern und/oder Signalen an Eingängen der Steuereinheit erfasst und abgespeichert werden und während der Selbsttestphase für die jeweils vorgegebenen Anlagenzustände aktuelle Werte der Parameter und/oder Signale an den Eingängen der Steuereinheit abgefragt und mit den entsprechenden Referenzwerten verglichen werden. Ergibt der Vergleich zwischen aktuellen Werten der Parameter und/oder Signalen und den jeweils entsprechenden, abgespeicherte Referenzwerten der Parameter und/oder Signale, dass ein vorgegebener Toleranzbereich verlassen wird, so kann der jeweilige Lastkreis angezeigt werden. Derartige Parameter- und/oder Signalwerte können z.B. Werte an einem Temperatursensorwert, ein Näherungsschalter-Ruhesignal, ein Drehzahlsensorwert, Dampfdruckwert, Funktionssignal, etc. sein. Dadurch können zusätzlich sehr einfach Fehler in der Verdrahtung der Anlage bzw. Maschine festgestellt werden.

Es ist vorteilhaft, wenn der vorgegebene Toleranzbereich für einen Vergleich zwischen aktuell gemessenen Strom- und/oder Spannungswerten mit dem entsprechenden Referenzstrom- und/oder Referenzspannungswerten angepasst werden kann. Durch die Einstellbarkeit des Toleranzbereichs können idealerweise Schwankungen bei der Strom- und/oder Spannungsmessung oder auch leichte Driften kompensiert werden, um z.B. unnötige Alarme zu verhindern. Durch regelmäßiges Durchführen des erfindungsgemäßen Verfahrens können beispielsweise typische Schwankungen in Lastkreisen der Anlage bzw. der Maschine erkannt und der Toleranzbereich entsprechend angepasst werden, um z.B. Pseudofehler durch einen zu eng gewählten Toleranzbereich bzw. das Übersehen von Fehlern durch einen zu breit gewählten Toleranzbereich zu vermeiden.

Der vorgegebene Toleranzbereich kann beispielsweise in Form eines Prozentsatz oder in Form eines Absolutbereichs angegebenen werden. Auch eine Kombination von beidem ist möglich. Weiterhin kann ein Toleranzbereich für alle zu überprüfenden Lastkreise vorgegeben werden oder es können auch für die jeweiligen Lastkreise spezifische Toleranzbereiche vorgegeben werden.

Idealerweise werden die jeweiligen Anlagenzustände und damit die jeweils eingeschalteten und ausgeschalteten Ausgangskanäle - d.h. die ein- bzw. ausgeschalteten Ausgängen der Stromversorgung bzw. die extern angeschalteten, jeweils eingeschalteten und ausgeschalteten Ausgangszweige - sowie die Spannungswerte für die Versorgungsspannung des jeweiligen Ausgangskanals oder die Stromwerte für den Versorgungstrom des jeweiligen Ausgangskanal durch die Steuereinheit vorgegeben. Durch die Steuereinheit, welche z.B. als speicherprogrammierbare Steuerung (SPS), als Mikrocontroller oder als Industrie-PC ausgeführt sein kann, können zumindest eine Mehrzahl der Lasteinheiten angesteuert - d.h. gezielt aktiviert und deaktiviert werden. Daher können von der Steuereinheit auch sehr einfach definierte, vorgegebenen Anlagenzustände hergestellt werden, bei welche z.B. einzelne Lasteinheiten bzw. Lastkreise aktiv sind und die restlichen Lasteinheiten des Steuersystems deaktiviert werden. Weiterhin kann die Steuereinheit eine Datenverbindung zur Stromversorgung aufweisen. Dadurch können von der Steuereinheit Steuersignal zum Einstellen vorgegebener Anlagenzustände an die getaktete Stromversorgung weitergeleitet werden. Von der getakteten Stromversorgung werden dann z.B. die entsprechenden Ausgangskanäle bzw. Ausgangszweige und damit die angeschlossen Lastkreise und Lasteinheiten entsprechend dem vorgegebenen Anlagenzustand ein- bzw. ausgeschaltet. Zusätzlich können der Stromversorgung von der Steuereinheit auch die Spannungswerte für Versorgungsspannung oder Stromwerte für den Versorgungsstrom beim jeweiligen Anlagenzustand vorgegeben werden oder am extern angeschalteten Ausgangszweig eingestellt werden.

Zweckmäßigerweise wird zwischen Ändern des vorgegebenen Spannungswertes der Versorgungsspannung oder des vorgegebenen Stromwertes des Versorgungsstroms beim jeweils vorgegebenen Anlagenzustand und Ermitteln des Referenzstromwerts oder Referenzspannungswertes wie des aktuellen Strommesswerts für diesen vorgegebenen Spannungswert der Versorgungsspannung bzw. des aktuellen Spannungsmesswertes für diesen vorgegebenen Stromwert des Versorgungsstroms eine vorgebbare Wartezeit vorgesehen. Auf diese einfache Weise können beispielsweise Einflüsse von Schwankungen im Stromverbrauch bzw. bei der Spannung, welche durch Anschalten der Versorgungsspannung an den jeweiligen Lastkreis (d.h. Einschalten des entsprechenden Ausgangskanals) bzw. durch Ändern des Spannungswertes der Versorgungsspannung oder durch Änderung des Stromwertes des Versorgungsstroms aufgrund der jeweiligen Lasteinheiten im Lastkreis entstehen, auf die Messung der jeweiligen Referenzwerte bzw. der aktuellen Messwerte (Strom oder Spannung) möglichst eliminiert werden. Die vorgebbare Wartezeit kann beispielweise derart gewählt werden, dass für die Messung der Stromwerte im jeweiligen Lastkreis ein stabiler Stromwert erreicht wurde, welcher z.B. eine relative geringe Schwankung (z.B. 3% Abweichung in einer Sekunde) aufweist. Ein Vorgabewert für die vorgebbare Wartezeit für die jeweiligen Lastkreise bzw. die entsprechenden Lasteinheiten kann z.B. während der Ermittlung der Referenzwerte für Strom oder Spannung bestimmt und dann in der Selbsttestphase verwendet werden. Damit lassen sich z.B. Wartezeiten bei Lasteinheiten bzw.

Lastkreisen ohne nennenswerte Einschwingzeit auf ein Minimum reduzieren. Bei Lasteinheiten mit relativ großen Einschwingzeiten kann beispielsweise zur vorgebbaren Wartezeit noch eine Sicherheitsreserve vorgesehen werden, um stabile Messwerte zu erhalten.

Weiterhin ist auch denkbar, einen Referenzstromwert und/oder aktuellen Strommesswert als Mittelwert aus mehreren Strommesswerten zu bilden, welche über eine vorgebbare Integrationszeit (z.B. 0,1 Sekunde, 10 Sekunden, etc.) gemessen werden, oder eine andere Art mathematischer Filterung vorzusehen, um eine Reduktion des Einflusses von Stromverbrauchsschwankungen - insbesondere bei Änderungen der Versorgungsspannung - im Lastkreis bzw. Rauschen bei der Ermittlung der Strommesswerte zu reduzieren. Zusätzlich kann bei einem erstmaligen Aufnehmen der Referenzstromwerte ein Einschwingvorgang beim Ändern der Versorgungsspannung (d.h. Einschalten der Versorgungsspannung im jeweiligen Lastkreis bzw. Ändern des Spannungswerts der Versorgungsspannung) mitermittelt werden. Die zeitliche Veränderung bzw. der Einschwingvorgang kann beispielsweise anhand eine zeitlichen Abfolge der Referenzstromwerte oder einer Verlaufsabspeicherung charakterisiert werden, wodurch beispielsweise ein zeitlicher Referenz-Stromverlauf des Einschwingvorgangs abgebildet werden kann. Eine ähnliche Vorgehensweise - z.B. mathematische Filterung - ist auch bei der Ermittlung der Referenzspannungswerte wie der aktuellen Messwerte der Spannung denkbar, um Einschwingvorgänge z.B. bei Anschalten oder Ändern des Versorgungsstroms zu reduzieren oder zu eliminieren.

Es ist weiterhin von Vorteil, wenn die vorgegebenen Spannungswerte für die Versorgungsspannung in vorgegebenen Spannungsschritten von einer Ausgangsversorgungsspannung (z.B. 0 Volt) bis zu einer vorgegebenen Nennspannung (z.B. 28 Volt) oder einer Betriebsgrenze der zumindest einen an den jeweiligen Lastkreis angeschlossenen Lastkreiseinheit angehoben werden. Durch eine Steigerung der Versorgungsspannung in vorgegebenen Spannungsschritten (z.B. in Stufen von 2 Volt) können beispielsweise lastkreisspezifische und/oder für die jeweilige Lasteinheit typische Stromwerte gemessen werden, welche eine zusätzliche Unterstützung beim Auffinden von Verdrahtungsfehler und eventuellen Fehlfunktionen bieten. So können z.B. kleine Sensoren einen Linearregler mit interner Elektronik aufweisen, durch welche der Sensor erst ab einer bestimmten Versorgungsspannung (z.B. 5 Volt oder 12 Volt) eingeschaltet wird und welche bis zu einer bestimmten Spannung (z.B. 28 Volt) z.B. einen Stromverbrauch konstant hält. Leistungsstärkere Verbraucher, wie z.B. Steuereinheiten, etc., weisen z.B. einen Tiefsetzsteller, etc. zum Erzeugen einer internen Hilfsspannung auf und reduzieren beispielsweise mit steigender Versorgungsspannung den Strom. Ein Schütz als Lasteinheit weist z.B. einen linear steigenden Stromverbrauch mit steigender Versorgungsspannung auf. Ein Gleichstrommotor kann beispielsweise bei geringer Spannung einen sehr geringen Widerstand aufweisen und z.B. einen hohen Strom aufnehmen, welcher beispielsweise mit beginnender Drehbewegung in einer flachen Kurve steigt oder sogar sinken kann.

Alternativ zu einer schritt- oder stufenweisen Steigerung der Versorgungsspannung am zumindest jeweils einen eingeschalteten Ausgangskanal der Stromversorgung, kann es auch günstig sein, wenn die vorgegebenen Spannungswerte für die Versorgungsspannung in Form einer linearen Spannungsrampe mit vorgebbarer Steigung von einer Ausgangsversorgungsspannung (z.B. 0 Volt) bis zu einer vorgegebenen Nennspannung (z.B. 28 Volt) oder einer Betriebsgrenze der zumindest einen an den jeweiligen Lastkreis angeschlossenen Lastkreiseinheit angehoben werden. Zusätzlich kann dabei auch ein Anstiegsgeschwindigkeit der Versorgungsspannung vorgegeben werden. Die Stromwerte im jeweils zumindest einen aktiven Lastkreis des jeweiligen Anlagenzustands werden dann synchron zum Anstieg der Versorgungsspannung gemessen. Um beispielsweise eine Durchlaufzeit des Verfahrens zu beschleunigen, können z.B. in Abhängigkeit der jeweiligen Lasteinheit bzw. der jeweiligen Lasteinheiten im Lastkreis für unterschiedliche Spannungsbereiche der Versorgungsspannung unterschiedliche Anstiegsgeschwindigkeiten gewählt werden. Ist beispielsweise bekannt, dass in einem Lastkreis ein Verbraucher bzw. eine Lasteinheit erst in einem Spannungswertebereich von 14 bis 16 Volt Versorgungsspannung eingeschaltet wird, so kann der Spannungswertebereich bis 14 Volt z.B. rascher (d.h. mit einer höheren Anstiegsgeschwindigkeit) durchlaufen werden. Für den Spannungswertebereich ab 14 Volt wird dann z.B. eine geringere Anstiegsgeschwindigkeit gewählt, um z.B. eine tatsächliche Einschaltspannung der Lasteinheit zu ermitteln, die entsprechenden Strommesswerte zu bestimmen und eventuelle Verdrahtungsfehler, etc. erkennen zu können.

Die ermittelten Referenzstromwerte und die gegebenfalls ermittelten Referenzspannungswerte können in der Steuereinheit des Anlagen- bzw. Maschinen-Steuersystems hinterlegt werden. Damit kann das erfindungsgemäße Verfahren - beispielsweise in Form eines Testprogramms - von der Steuereinheit durchgeführt werden. Zusätzlich zur Vorgabe der zu durchlaufenden Anlagenzustände kann die Steuereinheit z.B. auch prüfen, ob z.B. in Lastkreisen angebrachte Sensoreinheiten bei Aktivierung des jeweiligen Lastkreises Messwerte zurückliefern. Derartige Messwerte bzw. Sensorsignal können zusätzlich zu den Referenzstromwerten und/oder -spannungswerten abgespeichert werden und bieten in der Selbsttestphase der Anlage bzw. Maschine eine zusätzliche Überprüfungsmöglichkeit für eine korrekte Verdrahtung bzw. ordnungsgemäße Funktionsweise vor allem von Sensoreinheiten im Steuersystem.

Alternativ oder zusätzlich, können die ermittelten Referenzstromwerte und die gegebenenfalls ermittelten Referenzspannungswerte an einer - meist als zentrale bzw. übergeordnete Einheit ausgestalteten - Auswerte- und/oder Datenverarbeitungseinheit übermittelt und dort hinterlegt werden. Die Referenzwerte können damit sehr einfach für die Überprüfung von mehreren bautyp-identen Anlagen bzw. Maschinen genutzt werden.

Weiterhin ist es günstig, wenn die vorgegebenen Anlagenzustände über die Auswerte- und/oder Datenverarbeitungseinheit ausgewählt werden. Damit kann z.B. auf einfache Weise ein Testprogramm für die Selbsttestphase der Anlage bzw. Maschine erstellt werden, welche z.B. bei einer Inbetriebnahme beim Benutzer der Anlage oder Maschine durchlaufen wird. Es können bei der Auswahl damit Anlagenzustände aus dem Testprogramm entfernt werden bzw. nicht ausgewählt werden, welche sich aufgrund von wiederholten Durchläufen des Testprogramms als nicht zielführend für die Überprüfung herausgestellt haben. Auf diese Weise kann der Durchlauf der Überprüfung beschleunigt werden, da beispielsweise nur relevante Anlagenzustände ausgewählt werden können. Zusätzlich kann z.B. für die Auswahl bereits eine Liste von Anlagenzuständen (wie z.B. Aktivierung einer Pumpe oder von Ventilen) vorgegeben werden, welche beispielsweise nicht zielführende, gefährliche oder unerwünschte Anlagenzustände nicht aufweist oder es können bei der Auswahl idealerweise diese Anlagenzustände ausgeschlossen werden.

Die aktuell gemessenen Stromwerte und die gegebenfalls gemessenen Spannungswerte für den jeweiligen Anlagenzustand können dann ebenfalls an die Auswerte- und/oder Datenverarbeitungseinheit weitergeleitet und dort abgespeichert werden. Die Speicherung der aktuellen Messwerte ermöglicht sehr einfach erweiterte Analyse- und Auswertemöglichkeiten. Weiterhin können Messergebnisse sehr einfach graphisch dargestellt werden oder zeitliche Entwicklungen in der Anlage bzw. Maschine beurteilt werden. Auf diese Weise können z.B. drohende Fehlfunktionen in Lastkreisen oder Veränderungen, welche zu Fehlfunktionen der Anlage oder Maschine führen können, zeitgerecht erkannt werden.

### Kurzbeschreibung der Zeichnung

Die Erfindung wird nachfolgend in beispielhafter Weise anhand der beigefügten Figuren erläutert. Es zeigen:
Figur 1 einen schematischen und beispielhaften Aufbau eines Steuersystems einer Anlage zur Durchführung des erfindungsgemäßen Verfahren zum Überprüfen von Lastkreisen
Figur 2 einen beispielhaften Ablauf des erfindungsgemäßen Verfahren zum Überprüfen von Lastkreisen eines Steuersystems in einer Anlage.

### Ausführung der Erfindung

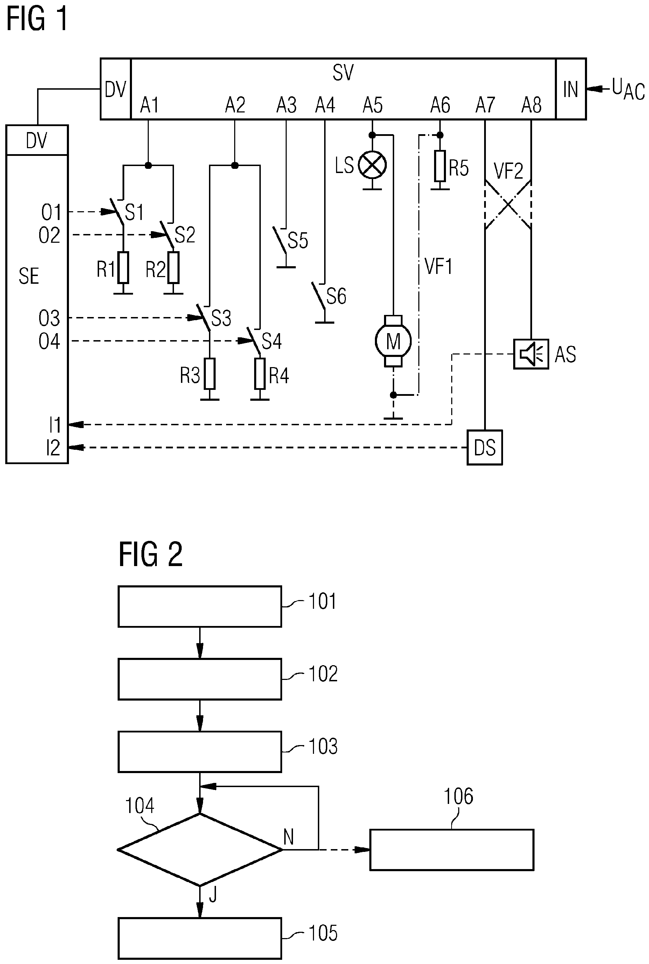

Figur 1 zeigt in schematischer Weise beispielhaft ein Steuersystem einer technischen Anlage bzw. einer komplexen Maschine. Das beispielhafte Steuersystem umfasst dabei zumindest eine Steuereinheit SE, welche z.B. als speicherprogrammierbare Steuerung oder kurz SPS ausgeführt sein kann. Alternativ kann auch ein Mikrocontroller oder eine Industrie-PC als Steuereinheit SE eingesetzt werden. Die Steuereinheit SE weist beispielsweise zur Ansteuerung von Lasteinheiten - z.B. zum Schalten von Schalteinheiten S1, ..., S4 - digitale Ausgänge O1, ..., O4 auf. Alternativ können die Schalteinheiten S1, ..., S4 auch Teil einer Ausgangsbaugruppe der Steuereinheit SE, insbesondere einer digitalen Ausgangsbaugruppe mit einer speicherprogrammierbaren Steuerung bzw. SPS, sein. Alternativ oder zusätzlich kann die Steuereinheit SE auch analoge Ausgänge aufweisen, an welche z.B. Aktoreinheiten bzw. Schalteinheiten angeschlossen sein können. In Figur 1 sind der Einfachheit halber die analogen Ausgänge der Steuereinheit SE nicht explizit dargestellt. Die digitalen Ausgänge O1, ..., 04 sowie die analogen Ausgänge bieten der Steuereinheit SE die Möglichkeit, die Anlage bzw. Maschine vor allem während des Betriebs anzusteuern und damit Betriebszustände der Anlage bzw. Maschine zu regeln bzw. herzustellen. Weiterhin weist die Steuereinheit SE beispielhaft digitale Eingänge I1, I2, auf, über welche z.B. Signale von Lasteinheiten - insbesondere Sensoreinheiten DS, AS - empfangen werden können. Über die an den Eingänge I1, I2 empfangenen Signale kann der Steuereinheit SE ein aktuelles Geschehen in der Anlage oder Maschine vermittelt werden und es können z.B. bestimmte Steuer- und Regelvorgänge ausgelöst werden. Die Steuereinheit SE kann auch analoge Eingänge für eine Anbindung und Abfrage von Sensoreinheiten aufweisen.

Das beispielhafte Steuersystem umfasst weiterhin z.B. eine getaktete Stromversorgung SV, welche über eine Eingangsseite IN mit einer Spannungsversorgung U_{AC} (z.B. einer 3-phasigen Wechselspannung) verbunden ist. Die Stromversorgung SV weist beispielsweise acht Ausgänge und damit acht Ausgangskanäle A1, ..., A8 auf, an welche die Lastkreise des Steuersystems z.B. direkt angeschlossen sind und über welche die Lastkreise des Steuersystems der Anlage bzw. der Maschine mit einer Versorgungsspannung (z.B. 24 V Gleichspannung) bzw. mit einem Versorgungsstrom von der Stromversorgung SV versorgt werden. Die Stromversorgung SV kann beispielsweise die Möglichkeit bieten, wie z.B. die SITOP PSU8600, dass für jeden Ausgangskanal A1, ..., A8 der Spannungswert der an den Lastkreis gelieferten Versorgungsspannung sowie der Strom individuell eingestellt und überwacht werden kann.

Alternativ kann das Steuersystem z.B. auch eine Stromversorgung SV aufweisen, an welche z.B. über eine externe Baugruppe (z.B. eine extern schaltbare Sicherungseinheit, etc.) mit zumindest zwei Ausgangszweigen angeschaltet ist, welche dann die zumindest zwei Ausgangskanäle A1, ..., A8 für die Stromversorgung SV bilden. Diese Ausgangszweige bzw. Ausgangskanäle A1, ..., A8 sind z.B. getrennt schaltbar und der Spannungswerte der an den Lastkreis gelieferte Versorgungsspannung wie der Strom kann individuell eingestellt und überwacht werden. Über die Ausgangskanäle A1, ..., A8 werden dann die jeweiligen Lastkreise bzw. die zu den Lastkreisen zugehörigen Lasteinheiten mit Strom bzw. Spannung versorgt.

Bei dem in Figur 1 beispielhaft dargestellten Steuerungssystem wird eine in den jeweiligen Lastkreis gelieferte Versorgungsspannung für den jeweils zugehörigen Ausgangskanal A1, ..., A8 vorgegeben, damit bildet der jeweilige von der zumindest einen Lasteinheit im jeweiligen Lastkreis aufgenommen Strom eine zu messenden Größe für die Referenzwerte und für die aktuellen Messwerte für eine jeweiligen Anlagenzustand. Alternativ dazu kann die Stromversorgung SV oder zumindest ein Ausgangskanal A1, ..., A8 der Stromversorgung SV beispielsweise als Stromquelle betrieben werden. Dabei wird als Vorgabewert dem jeweiligen Ausgangskanal A1, ..., A8 ein Versorgungs- oder Laststrom vorgegeben oder eingeprägt. Es wird dann eine Spannung für die Referenzwerte bestimmt bzw. als aktueller Messwert für den jeweiligen Anlagenzustand gemessen, wobei sich die Spannung in Abhängigkeit einer Impedanz der jeweiligen Lasteinheit im Lastkreis einstellt und gegebenenfalls mit einer höheren Genauigkeit gemessen werden kann bzw. bei Lasten mit kapazitiven Anteil bzw. mit Kondensatoren einfacher messbar ist.

Weiterhin können die Stromversorgung SV sowie die Steuereinheit SE des Steuersystems Schnittstellenmodule DV aufweisen, über welche eine z.B. bidirektionale Datenverbindung zum Übertragen von Steuersignalen und Dateninformationen hergestellt werden kann. Für die Datenverbindung kann beispielsweise Profinet (Process Field Network) - ein der offene Industrie-Ethernet-Standard der PROFIBUS-Nutzerorganisation - verwendet werden.

Für eine Spannungsversorgung der Steuereinheit SE kann - wie beispielhaft in Figur 1 dargestellt - eine eigene Stromversorgung, welche in der Figur 1 nicht dargestellt ist, vorgesehen sein. Alternativ kann der Steuereinheit SE auch von der getakteten Stromversorgung SV des Steuersystems die entsprechende Versorgungsspannung zur Verfügung gestellt werden. Dazu könnte die Steuereinheit SE beispielweise an einen ersten Ausgangskanal A1 der Stromversorgung SV angebunden sein.

An die Ausgangskanäle A1, ..., A8 sind die Lastkreise des Steuersystems der Anlage bzw. Maschine angeschlossen, welche jeweils zumindest eine Lasteinheit - z.B. zumindest eine Aktor- bzw. Schalteinheit oder Sensoreinheit - aufweisen können. Bei dem in Figur 1 beispielhaft dargestellten Steuersystem sind beispielsweise am ersten Ausgangskanal A1 und an einem zweiten Ausgangskanal A2 Schalteinheiten S1, S2, S3, S4 sowie zugehörige Lastwiderstände R1, R2, R3, R4 angebunden, welche über die jeweilige Schalteinheit S1, S2, S3, S4 und mittels Ansteuerung durch die jeweiligen digitalen Ausgänge O1, O2, 03, 04 der Steuereinheit SE zu- oder weggeschalten werden können. An einen dritten und vierten Ausgangskanal A3, A4 sind ebenfalls als Lasteinheiten weitere Aktor- bzw. Schalteinheiten S5, S6 (z.B. Schütze, Magnetventile, etc.) z.B. zum Ein- bzw. Ausschalten eines elektrischen Ventils, eines Motors oder eines Moduls für eine Antriebssteuerung, etc. angebunden. Diese Aktor- bzw. Schalteinheiten S5, S6 können beispielsweise von der Steuereinheit SE des Steuersystems oder einer weiteren Steuereinheit angesteuert werden.

An einem fünften Ausgangskanal A5 der Stromversorgung SV ist beispielsweise ein Lichtsignal LS sowie ein Motor M z.B. zum Betreiben einer Lüftereinheit angeschlossen. An einem sechsten Ausgangskanal A6 der Stromversorgung SV ist z.B. ein weiterer Lastwiderstand R5 angebunden. Dabei ist beispielsweise der Motor M bzw. die Lüftereinheit fälschlicherweise nicht vom fünften Ausgangskanal A5 gegen Masse - wie mittels strichlierter Linie dargestellt - geschaltet, sondern aufgrund eines ersten Verdrahtungsfehlers VF1 (z.B. beim Aufbau der Anlage bzw. der Maschine) mit dem sechsten Ausgangskanal A6 verbunden. Der erste Verdrahtungsfehler VF1 ist dabei als strich-punktierte Linie dargestellt.

Ein weiterer, zweiter beispielhafter Verdrahtungsfehler VF2 ist bei der Verdrahtung eines siebten und achten Ausgangskanals A7, A8 der Stromversorgung SV dargestellt. An den siebten und achten Ausgangskanal A7, A8 ist z.B. als Lasteinheit jeweils eine Sensoreinheit DS, AS angebunden, von welcher beispielsweise ein Eingangssignal an den entsprechenden digitalen Eingang I1, I2 der Steuereinheit SE geliefert wird. Bei einer richtigen Verdrahtung - wieder mittels strichlierter Linie dargestellt - wäre an den siebenten Ausgangskanal A7 z.B. ein Drucksensor DS angeschaltet, welcher ab Erreichen eines Schwellwerts ein Eingangssignal an den digitalen Eingang I2 der Steuereinheit SE meldet, und an den achten Ausgangskanal A8 eine akustische Signaleinheit AS, welche während des Betriebs ein Funktionssignal an den digitalen Eingang I1 der Steuereinheit SE abgibt. Aufgrund des zweiten Verdrahtungsfehlers VF2 - wie als strich-punktierte Linie dargestellt - wurden die Anschaltung der beiden Sensoreinheiten DS, AS vertauscht, wodurch nun die akustische Signaleinheit AS über den siebenten Ausgangskanal A7 und der Drucksensor DS über den achten Ausgangskanal A8 die entsprechende Versorgungsspannung erhält. Die jeweiligen Signalausgänge des Drucksensors DS bzw. der akustischen Signaleinheit AS sind jedoch mit den jeweils korrekten digitalen Eingängen I1, I2 der Steuereinheit SE verbunden.

Die Figur 2 zeigt beispielhaft einen Ablauf des erfindungsgemäßen Verfahrens zum Überprüfen von Lastkreisen in einer Anlage bzw. eines Steuersystems einer Anlage wie beispielhaft in Figur 1 dargestellt.

Bei der Durchführung des erfindungsgemäßen Verfahrens werden insbesondere in einem Referenzwertermittlungsschritt 101 zum Ermitteln von Referenzstrom- und gegebenenfalls Referenzspannungswerten in den jeweiligen Ausgangskanälen A1, ..., A8 der Stromversorgung SV sowie in einem Messschritt 103, bei welchem aktuelle Stromwerte an und gegebenenfalls aktuelle Spannungswerte in den jeweiligen Ausgangskanälen A1, ..., A8 der Stromversorgung SV bestimmt werden, Anlagenzustände vorgegeben. Diese Anlagenzustände werden z.B. über Steuerbefehle der Steuereinheit SE hervorgerufen, durch welche Ausgangskanäle A1, ..., A8 der Stromversorgung SV z.B. durch die Stromversorgung SV selbst ein- bzw. ausgeschaltet werden und gegebenfalls Ausgänge O1, ..., O4 der Steuereinheit SE aktiviert bzw. deaktiviert werden. Zusätzlich können für vorgegebenen Anlagenzustände auch Eingänge I1, I2 der Steuereinheit SE z.B. auf anstehende Parameterwerte bzw. Signalwerte von Sensoreinheiten DS, AS abgefragt werden.

Als vorgegebener Anlagenzustand wird dabei ein Betriebsfall der Anlage bzw. Maschine betrachtet, welcher über eine Schalterstellung durch die Steuereinheit SE und aktivierte - d.h. mit Versorgungsspannung versorgte - Lastkreise definiert bzw. hervorgerufen wird. D.h. für einen Anlagenzustand wird zumindest einer der Ausgangskanäle A1, ..., A8 der Stromversorgung SV aktiv bzw. eingeschaltet und der zugehörige Lastkreis von der Stromversorgung SV mit einer Spannung versorgt. Zusätzlich kann - sofern der aktiv geschaltete Lastkreis über eine von der Steuereinheit SE angesteuerte Lasteinheit S1, ..., S4 verfügt - der entsprechende Ausgang O1, ..., O4 der Steuereinheit SE aktiviert werden oder wenn der aktiv geschaltete Lastkreis über einen Sensoreinheit DS, AS verfügt, der entsprechende Eingang I1, I2 der Steuereinheit abgefragt werden. Derartige Inputs (z.B. Temperaturwerte, Drehzahlwerte, Dampfdruckwerte, Funktionssignale, etc.) können beispielsweise zusätzlich genutzt werden, um Lastkreis - insbesondere eine korrekte Verdrahtung einer Sensoreinheit DS, AS - zu überprüfen. Es stehen damit für den jeweiligen Anlagenzustand insbesondere in der Steuereinheit SE bestimmte Schalterstellungen und Parameter an. Für die Ermittlung von Referenzwerten sowie von aktuellen Messwerten von Strom und Spannung in einem Lastkreis werden idealerweise Anlagenzustände vorgegeben, bei welchen beispielsweise nur ein Ausgangskanal A1, ..., A8 und z.B. nur ein Ausgang O1, ..., O4 der Steuereinheit SE gleichzeitig aktiviert sind, sofern der entsprechende Lastkreis über ein von der Steuereinheit SE angesteuertes Lastelement S1, ..., S4 verfügt.

Für das in Figur 1 beispielhaft dargestellte Steuersystem einer technischen Anlage oder Maschine, welches mit dem erfindungsgemäßen Verfahren überprüft werden soll, können damit beispielsweise zumindest zwölf funktionelle Anlagezustände definiert und gegebenenfalls z.B. in Form eines Testprogramms vorgegeben werden. Für diese zwölf funktionellen Anlagenzustände können z.B. über Steuerbefehle, welche von der Steuereinheit SE über die Datenverbindung DV an die Stromversorgung SV gesendet werden, jeweils einer der acht Ausgangskanäle A1, ..., A8 aktiviert werden. Zusätzlich wird jeweils einer der digitalen Ausgänge O1, ..., O4 der Steuereinheit SE aktiviert, um die zugehörige Schalteinheit S1, ..., S4 einzuschalten, wenn der entsprechende erste bzw. zweite Ausgangskanal A1, A2 der Stromversorgung SV eingeschaltet ist. D.h. für einen beispielhaften ersten Anlagenzustand wird der erste Ausgangskanal A1 aktiviert, die restlichen Ausgangskanäle A2 bis A8 bleiben abgeschaltet. Dann kann für einen beispielhaften zweiten Anlagenzustand nach Aktivierung des ersten Ausgangskanals A1 zusätzlich der erste digitale Ausgang O1 der Steuereinheit SE aktiviert werden, um die erste Schalteinheit S1 im an den ersten Ausgangskanal A1 angeschlossenen Lastkreis zu schalten und den zugehörigen Lastwiderstand R1 zuzuschalten. Für einen beispielhaften dritten Anlagenzustand bleiben z.B. der erste Ausgangskanal A1 eingeschaltet und die restlichen Ausgangskanäle A2, ..., A8 der Stromversorgung SV ausgeschaltet. Es wird nun aber der erste digitale Ausgang O1 der Steuereinheit SE deaktiviert (d.h. der zugehörige Lastwiderstand R1 wird weggeschaltet) und der zweite digitale Ausgang 02 der Steuereinheit SE aktiviert, um die zweite Schalteinheit S2 im an den ersten Ausgangskanal A1 angeschlossenen Lastkreis zu schalten und den zugehörigen Lastwiderstand R2 zuzuschalten. Entsprechende Anlagenzustände können beispielsweise auch für den zweiten Ausgangskanal A2 der Stromversorgung in der beispielshaft in Figur 1 dargestellten Anlage vorgegeben werden. Bei den restlichen Anlagenzuständen wird beispielsweise jeweils einer der Ausgangskanäle A3 bis A8 der Stromversorgung eingeschaltet bzw. aktiviert, um den zugehörigen Lastkreis mit einer Versorgungsspannung zu versorgen.

Für eine Reduktion der Testzeit können beispielweise auch mehrere Ausgangskanäle A1, ..., A8 der Stromversorgung SV und/oder mehrere Ausgänge O1, ..., O4 der Steuereinheit SE gleichzeitig aktiviert werden. Für das in Figur 1 dargestellte Steuersystem einer Anlage oder Maschine könnten beispielsweise der oben beschriebene zweite und dritte Anlagenzustand zusammengefasst werden, indem zusätzlich zum ersten Ausgangskanal A1 der Stromversorgung SV gleichzeitig der erste und der zweite Ausgang O1, O2 der Steuereinheit aktiviert, die zugehörigen Schaltelemente S1, S2 im an den ersten Ausgangskanal A1 der Stromversorgung SV angeschlossenen Lastkreis geschaltet und die zugehörigen Lastwiderstände R1, R2 gleichzeitig zugeschaltet werden. Analog können auch die Anlagenzustände für den zweiten Ausgangskanal A2 der Stromversorgung SV z.B. zusammengefasst werden.

Bei realen Anlagen können wesentlich mehr Anlagenzustände definiert und für das erfindungsgemäße Verfahren verwendet werden. Dabei können allerdings nicht zielführende, gefährliche oder nicht sinnvolle Anlagenzustände (z.B. ein Anlagenzustand, durch welchen eine Pumpe oder ein Ventil ungewollt aktiviert wird) ausgeschlossen werden. Weiterhin können die vorgegebenen bzw. als sinnvoll erachteten Anlagenzustände in Form eines Testprogramm zusammengefasst werden, welches z.B. für eine Selbsttestphase einer Anlage bzw. Maschine, welche bei einem Benutzer in Betrieb genommen wird, angepasst werden kann - d.h. die Anlagenzustände können anlagen- und/oder benutzerspezifisch ausgewählt und vorgegeben werden.

Für eine Überprüfung der Lastkreise in einer Anlage gemäß dem erfindungsgemäßen Verfahren werden im Referenzwertermittlungsschritt 101 Referenzstromwerte für einen jeweils vorgegebenen Anlagenzustand - d.h. bei zumindest einem eingeschalteten Ausgangskanal A1, ..., A8 der Stromversorgung SV - bei vorgegebenen Spannungswerten für die Versorgungsspannung ermittelt. D.h. es wird z.B. mit Hilfe der Steuereinheit SE ein vorgegebener Anlagenzustand (z.B. der erste Anlagenzustand mit eingeschaltetem ersten Ausgangskanal A1 der Stromversorgung SV; der zweite Anlagenzustand mit aktiviertem ersten Ausgangskanals A1 und aktiviertem ersten digitalen Ausgang O1 der Steuereinheit SE; usw.) hervorgerufen. Dann werden beispielsweise am zumindest einen eingeschalteten (z.B. dem ersten) Ausgangskanal A1 der Stromversorgung SV die vorgegebenen Spannungswerte für die Versorgungsspannung des zugehörigen Lastkreis z.B. von der Stromversorgung SV eingestellt und die zugehörigen Stromwerte ermittelt.

Alternativ können im Referenzwertermittlungsschritt 101 anstatt der Referenzstromwerte für einen jeweils vorgegebenen Anlagenzustand - d.h. bei zumindest einem eingeschalteten Ausgangskanal A1, ..., A8 der Stromversorgung SV - Referenzspannungswerte bei vorgegebenen Stromwerten des Versorgungsstroms ermittelt. D.h. es wird z.B. mit Hilfe der Steuereinheit SE ein vorgegebener Anlagenzustand (z.B. der erste Anlagenzustand mit eingeschaltetem ersten Ausgangskanal A1 der Stromversorgung SV; der zweite Anlagenzustand mit aktiviertem ersten Ausgangskanals A1 und aktiviertem ersten digitalen Ausgang O1 der Steuereinheit SE; usw.) hervorgerufen. Dann werden beispielsweise am zumindest einen eingeschalteten (z.B. dem ersten) Ausgangskanal A1 der Stromversorgung SV die vorgegebenen Stromwerte für den Versorgungsstrom des zugehörigen Lastkreis z.B. von der Stromversorgung SV eingeprägt und die zugehörigen Spannungswerte ermittelt.

Zusätzlich können auch an den restlichen Ausgangskanälen A2, ..., A8, welche in vorgegebenen Anlagenzustand ausgeschaltet sind, Spannungswerte als weitere Referenzspannungswerte und/oder Stromwerte als weitere Referenzstromwerte bestimmt werden sowie die Parameter- und/oder Signalwerte der Sensoreinheiten DS, AS als Referenzwerte abgefragt werden, welche an den Eingängen I1, I2 der Steuereinheit SE anliegen.

Die Referenzstromwerte können beispielsweise mittels einer Referenzanlage bzw. -maschine z.B. von einem Hersteller in einer Entwicklungstestphase (d.h. nach erfolgter Entwicklung z.B. einer Serienanlage bzw. -maschine) vorgenommen werden. Alternativ oder zusätzlich, können z.B. bei benutzerspezifischen Anlagen oder Maschine die Referenzstromwerte während einer erstmaligen Inbetriebnahme der Anlage oder Maschine ermittelt oder aus Stromwerten abgeleitet werden, welche während des laufenden Betriebs an den jeweiligen Ausgangskanälen A1, ..., A8 für die vorgegebenen Anlagenzustände gemessen werden. Analog dazu können auch gegebenfalls Referenzspannungswerte für vorgegebenen Anlagenzustände auf einer Referenzanlage bzw. -maschine oder bei erstmaliger Inbetriebnahme der Anlage oder Maschine bestimmt oder aus laufend im Betrieb gemessenen Spannungswerte abgeleitet werden.

In einem Speicherschritt 102 werden die für die vorgegebenen Anlagenzustände und vorgegebenen Spannungswerte der Versorgungsspannung des jeweiligen Lastkreises ermittelten Referenzstromwerte abgespeichert. Die Referenzstromwerte können dabei z.B. in der Steuereinheit SE des Steuersystems der Anlage gespeichert werden bzw. auf die Steuereinheit SE einer typgleichen Anlage bzw. Maschine übertragen werden. Alternativ oder zusätzlich können die Referenzstromwerte auch an eine z.B. zentral verfügbare Auswerte- und/oder Datenverarbeitungseinheit übertragen und dort abgespeichert werden. Werden für die vorgegebenen Anlagenzustände alternativ Referenzspannungswerte bei vorgegebenen Stromwerten des Versorgungstroms im jeweiligen Lastkreis oder zusätzlich weitere Referenzspannungswerte an ausgeschalteten Ausgangskanälen A1, ..., A8 bestimmt, so können diese ebenfalls in der Steuereinheit SE abgespeichert werden. Alternativ oder zusätzlich, können auch die Referenzspannungswerte an die Auswerte- und/oder Datenverarbeitungseinheit übertragen und gemeinsam mit den entsprechenden Referenzstromwerten dort abgelegt werden. D.h. im Speicherschritt 102 wird für jeden vorgegebenen Anlagenzustand zumindest ein Referenzstromwert für jeden vorgegebenen Spannungswert der Versorgungsspannung im jeweiligen Lastkreis oder ein Referenzspannungswert für jeden vorgegebenen Stromwert des Versorgungsstroms im jeweiligen Lastkreis abgespeichert.

Mit dem Messschritt 103 wird auf der jeweils zu überprüfenden Anlage oder Maschine eine Selbsttestphase gestartet, welche bei der Inbetriebnahme z.B. nach einem Transport und Wiederinstallation oder einer Neuinstallation der jeweiligen Anlage oder Maschine oder auch bei einem Neustart während des laufenden Betriebs der Anlage bzw. Maschine durchlaufen werden kann. Im Messschritt 103 werden dann von der Steuereinheit SE z.B. mittels Befehlen über die Datenverbindung DV an die Stromversorgung SV und gegebenenfalls mittels Signalen an den Ausgängen der Steuereinheit SE angebundenen Lasteinheiten S1, ..., S4 gezielt die vorgegebenen Anlagenzustände hervorgerufen. Die vorgegebenen Anlagenzustände können beispielweise aus einer Liste an möglichen bzw. für die Anlage bzw. Maschine sinnvollen Anlagenzuständen ausgewählt werden. Diese Liste kann z.B. vor oder während des Referenzwerteermittlungsschritt 101 erstellt werden und z.B. in der Steuereinheit SE oder in der Auswerte- und/oder Datenverarbeitungseinheit abgelegt sein.

Weiterhin werden im Messschritt 103 für jeden vorgegebenen Anlagenzustand die vorgegebenen Spannungswerte der Versorgungsspannung am jeweils zumindest einen eingeschalteten Ausgangskanal A1, ..., A8 der Stromversorgung vorgegeben - z.B. durch die Stromversorgung SV über einen Befehl der Steuereinheit SE. Für jeden vorgegebenen Spannungswert der Versorgungsspannung wird dann am jeweils zumindest einen eingeschalteten Ausgangskanal A1, ..., A8 der Stromversorgung SV ein aktueller Stromwert gemessen und abgespeichert. D.h. es wird für jeden vorgegebenen Anlagenzustand zu jedem vorgegebenen Spannungswert der Versorgungsspannung ein aktueller Stromwert erhalten, welcher dann im Bezug auf den entsprechenden Referenzstromwert ausgewertet werden kann.

Um die vorgegebenen Spannungswerte der Versorgungsspannung für den jeweils aktuell vorgegebenen Anlagenzustand im Messschritt 103 zu durchlaufen, kann beispielsweise die Versorgungsspannung ausgehend von einer Ausgangsversorgungsspannung (z.B. 0 Volt) in vorgegebenen Spannungsschritten (z.B. 2 Volt) bis zu einer vorgegebenen Nennspannung (z.B. 24 oder 28 Volt) angehoben werden. Alternativ kann die Versorgungsspannung auch in Form einer linearen Spannungsrampe mit vorgebbarer Steigung bzw. Anstiegsgeschwindigkeit von einer Ausgangsversorgungsspannung (z.B. 0 Volt) bis zu einer vorgegebenen Nennspannung (z.B. 24 oder 28 Volt) angehoben werden und auf diese Weise vorgegebenen Spannungswert der Versorgungsspannung durchlaufen werden. Wird der vorgegebene Spannungswert der Versorgungsspannung am zumindest einen eingeschalteten Ausgangskanal A1, ..., A8 der Stromversorgung SV entweder inkrementell oder mittels eines rampenförmigen Anstiegs auf einen nächsten vorgegebenen Spannungswert geändert, so kann zwischen Ändern des Spannungswert der Versorgungsspannung und einem Messen des aktuellen Stromwerts im zumindest einen eingeschalteten Ausgangskanal A1, ..., A8 der Stromversorgung SV ein vorgegebene Wartezeit vorgesehen sein. Auf diese Weise werden z.B. Stromschwankungen durch Einschwingvorgänge aufgrund der Spannungsänderung, etc. nicht mitgemessen, sondern ein möglichst statischer bzw. konstanter aktueller Stromwert gemessen. Weiterhin ist es möglich, eine Mittelwertbildung von Messwerten über eine vorgebbare Integrationszeit (z.B. 0,1 oder 10 Sekunden) oder eine andere mathematische Filterung für eine Reduktion von Stromschwankungen und/oder Rauschen bei der Ermittlung der aktuellen Stromwerte vorzusehen. Die Filterungen können auch auf mehrere, in vorgegebener Reihenfolge vorgenommene Strommessungen erfolgen, um über einen vorgebbaren Zeitraum (z.B. 1 Minute) in vorgebbaren Abständen (z.B. alle 10 Sekunden) gefilterte Messwerte zu ermitteln und auf diese Weise einen Einschwingvorgangs einer Lasteinheit bzw. eines Verbrauchers beschreiben zu können.

Für die Ermittlung der Referenzwerte von Strom oder Spannung im Referenzwerteermittlungsschritt 101 können ebenfalls die oben beschriebenen Methoden zur Änderung der vorgegebenen Spannungswerte der Versorgungsspannung am zumindest einen aktiven Ausgangskanal A1, ..., A8 beim jeweils vorgegebenen Anlagenzustand angewendet werden. Dabei kann ebenfalls zwischen Ändern des Spannungswertes der Versorgungsspannung und Ermitteln des Referenzstromwertes bzw. zwischen Änderung des Stromwerts des Versorgungsstroms und Ermittlung des Referenzspannungswerts eine Wartezeit vorgesehen sein bzw. eine Filtermethode für die Reduktion von Schwankungen und/oder Rauschen z.B. durch Einschwingvorgänge angewendet werden. Dabei ist zu beachten, dass im Messschritt 103 dieselben Methoden zur Spannungsänderung des Spannungswertes der Versorgungsspannung und für die Reduktion von Stromschwankungen (z.B. Wartezeit, mathematische Filterung, mehrere Messungen in vorgegebener Reihenfolge über einen vorgebbaren Zeitraum in vorgebbarem Abstand, etc.) zum Einsatz kommen.

Zusätzlich können im Messschritt 103 auch aktuelle Spannungswerte an den im jeweils vorgegebenen Anlagenzustand ausgeschalteten Ausgangskanälen A1, ..., A8 der Stromversorgung SV gemessen werden. Es ist auch möglich, aktuelle Stromwerte an jenen Ausgangskanälen A1, ..., A8 der Stromversorgung SV zu messen, welche im jeweils vorgegebenen Anlagenzustand ausgeschaltet sind. Auch diese aktuell gemessenen Spannungs- und Stromwerte werden abgespeichert und können für eine Auswertung und Überprüfung der Lastkreise der Anlage bzw. Maschine herangezogen werden.

Alternativ kann im Messschritt 103 anstatt des aktuellen Stromwertes der aktuelle Spannungswert am zumindest einen eingeschalteten Ausgangskanal A1, ..., A8 für den jeweils vorgegebenen Anlagenzustand gemessen werden. Dazu werden für den jeweils vorgegebenen Anlagenzustand die vorgegebenen Stromwerte des Versorgungsstroms am jeweils zumindest einen eingeschalteten Ausgangskanal A1, ..., A8 eingeprägt - z.B. durch die Stromversorgung SV über einen Befehl der Steuereinheit SE. Für jeden vorgegebenen Stromwert des Versorgungsstroms wird dann am jeweils zumindest einen eingeschalteten Ausgangskanal A1, ..., A8 der Stromversorgung SV ein aktueller Spannungswert gemessen und abgespeichert. D.h. es wird für jeden vorgegebenen Anlagenzustand zu jedem vorgegebenen Stromwert des Versorgungsstrom ein aktueller Spannungswert erhalten, welcher dann im Bezug auf den entsprechenden Referenzspannungswert ausgewertet werden kann. Für die Ermittlung der aktuellen Messwerte der Spannung können ebenfalls die oben beschriebenen Methoden zur Änderung der vorgegebenen Stromwerte des Versorgungsstroms am zumindest einen aktiven Ausgangskanal A1, ..., A8 beim jeweils vorgegebenen Anlagenzustand angewendet werden und entsprechende Filtermethoden oder eine Wartezeit angewendet werden, um Einschwingvorgänge abzuwarten und Rauschen zu reduzieren.

Ein Abspeichern der aktuell an dem zumindest einen aktiven Ausgangskanal A1, ..., A8 der Stromversorgung SV gemessenen Stromwerte oder Spannungswerte sowie der gegebenenfalls an den nicht aktiven Ausgangskanälen A1, ..., A8 der Stromversorgung SV gemessenen Spannungswerte kann z.B. ebenfalls in der Steuereinheit SE erfolgen, welche dann beispielsweise auch eine Auswertung durchführt. Die gemessenen Stromwerte und Spannungswerte können aber auch an die Auswerte- und/oder Datenverarbeitungseinheit weitergeleitet und dort hinterlegt werden. Die Auswertung erfolgt dann beispielsweise ebenfalls durch die Auswerte- und/oder Datenverarbeitungseinheit.

In einem Prüfschritt 104 werden dann für jeden vorgegebenen Anlagenzustand die aktuell gemessenen Stromwerte, welche zu den jeweiligen, vorgegebenen Spannungswerten der Versorgungsspannung am zumindest einen eingeschalteten Ausgangskanal A1, ..., A8 der Stromversorgung SV für den jeweils vorgegebenen Anlagenzustand ermittelt wurden, mit den entsprechenden Referenzwerten verglichen. Dabei werden die im Referenzschritt 101 für den jeweils selben Anlagezustand und für die entsprechenden Spannungswerte der Versorgungsspannung ermittelten Referenzstromwerte herangezogen. Beim Vergleich zwischen aktuell gemessenen Stromwerten und den entsprechenden Referenzwerten wird geprüft, ob beim aktuell geprüften, vorgegebenen Anlagenzustand bei einem der vorgegeben Spannungswerte der Versorgungsspannung am zumindest einen aktiven Ausgangskanal A1, ..., A8 bzw. im zumindest einen aktiven Lastkreis des geprüften Anlagenzustands ein vorgegebener Toleranzbereich überschritten wird. Wurden im Messschritt 103 anstatt aktuellen Stromwerten aktuelle Spannungswerte gemessen, so werden im Prüfschritt 104 diese mit den im Referenzschritt 101 ermittelten, entsprechenden Referenzspannungswerten verglichen und die Einhaltung des vorgegebenen Toleranzbereichs überprüft.

Der vorgegebene Toleranzbereich kann dabei z.B. in Form eines Prozentsatzes oder in Form eines Absolutbereichs angegeben sein. Es kann dabei ein Toleranzbereich für alle zu prüfenden Lastkreise der Anlage bzw. Maschine vorgesehen werden. Es ist allerdings auch möglich, lastkreisspezifisch individuell Toleranzbereiche vorzugeben oder Toleranzbereiche für z.B. gleich oder ähnlich ausgeführte Lastkreise vorzusehen. Weiterhin kann der Toleranzbereich angepasst werden, wenn z.B. im Laufe des erfindungsgemäßen Verfahren bzw. bei mehrmaliger Anwendung erkannt wird, dass der vorgegebene Toleranzbereich z.B. zu eng oder zu weit gewählt worden ist. Durch einen z.B. zu eng gewählten Toleranzbereich können beispielsweise durch Schwankungen in Lastkreisen und/oder z.B. Alterserscheinungen von Lasteinheiten Pseudofehler produziert werden. D.h. es wird trotz korrekter Anlagenfunktion in einem Lastkreis ein Fehler angezeigt. Bei einem zu weit gewählten Toleranzbereich können beispielsweise tatsächlich vorliegende Verdrahtungsfehler und/oder Funktionsfehler von Lasteinheiten übersehen werden. Eine Anpassung des vorgegebenen Toleranzbereichs kann beispielsweise auf Basis von zu verschiedenen Zeitpunkten abgespeicherten Strommesswerten in den Lastkreisen vorgenommen werden.

Wird im Prüfschritt 104 festgestellt, dass beim aktuell geprüften, vorgegebenen Anlagenzustand zumindest bei einem vorgegebenen Spannungswert der Versorgungsspannung am zumindest einen eingeschalteten Ausgangskanal A1, ..., A8 der Stromversorgung SV vom Vergleich zwischen aktuell gemessenem Stromwert und entsprechendem Referenzstromwert der Toleranzbereich nicht eingehalten wird, so wird in einem Anzeigeschritt 105 der an den zumindest einen eingeschalteten Ausgangskanal angeschlossene Lastkreis angezeigt. Die Anzeige des jeweiligen Lastkreises kann z.B. über die Steuereinheit SE erfolgen. Dazu kann beispielsweise eine der Steuereinheit SE zugeordnete Anzeigeeinheit (z.B. Display, mobile Anzeigeeinheit, etc.) verwendet werden. Analoges gilt, wenn anstatt eines Stroms eine Spannung für den jeweiligen Anlagezustand im jeweils aktiv geschalteten Lastkreis gemessen wird.

Bei Durchführung des Prüfschrittes 104 auf einer Auswerte- und/oder Datenverarbeitungseinheit kann die Anzeige des jeweiligen Lastkreises, bei welchem ein Verdrahtungsfehler aufgrund der gemessenen aktuellen Stromwerte vermutet wird, im Anzeigeschritt 105 beispielsweise über eine Ausgabeeinheit der Auswerte- und/oder Datenverarbeitungseinheit erfolgen. Dabei können z.B. die gemessenen Werte von Strom oder Spannung und/oder der Vergleich mit den Referenzstrom- oder - spannungswerten graphisch aufbereitet werden - beispielsweise in Form von Tabellen, Kurven, etc. Bei einer Auswertung durch eine Auswerte- und/oder Datenverarbeitungseinheit können weiterhin auch früher gespeicherte Strom- oder Spannungsmesswerte der Lastkreise z.B. im Vergleich zu den aktuell gemessenen Strom- oder Spannungsmesswerten der Lastkreise graphisch aufbereitet auf einer Ausgabeeinheit ausgegeben und dargestellt werden.

Wird im Prüfschritt 104 bei dem aktuell geprüften, vorgegebenen Anlagenzustand kein Verlassen (d.h. betragsmäßiges oder prozentuelles Überschreiten oder Über-/Unterschreiten) des vorgegebenen Toleranzbereichs durch den Vergleich zwischen den jeweils aktuell gemessenen Werten mit den entsprechenden Referenzwerten festgestellt, so wird ein nächster vorgegebenen Anlagenzustand überprüft, welcher für die zu überprüfende Anlage bzw. Maschine vorgegeben wurde und für welchen aktuell gemessene Werte sowie Referenzwerte verfügbar sind. Wird bei einem der weiteren, vorgegebenen Anlagenzustände ein Verlassen des vorgegebenen Toleranzbereichs bzw. der z.B. lastkreisspezifisch vorgegebenen Toleranzbereiche durch die entsprechenden Vergleiche von aktuell gemessenen Werten mit den entsprechenden Referenzwerten festgestellt, so können die jeweiligen Lastkreise im Anzeigeschritt 105 ebenfalls angezeigt werden. Treten auch bei den weiteren, vorgegebenen Anlagenzuständen keine Überschreitungen des Toleranzbereichs bzw. der z.B. lastkreisspezifisch vorgegebenen Toleranzbereiche durch die entsprechenden Vergleiche von aktuell gemessenen Werten mit den entsprechenden Referenzwerten auf, so wird das erfindungsgemäße Verfahren mit einem Abschlussschritt 106 beendet. Im Abschlussschritt 106 kann z.B. ausgegeben werden, dass keine Auffälligkeiten bei den geprüften Lastkreisen der Anlage bzw. Maschine festgestellt werden konnten.

Zusätzlich können - sofern diese im Messschritt 103 gemessen wurden - im Prüfschritt 104 auch die an den im jeweiligen Anlagenzustand ausgeschalteten Ausgangskanälen A1, ..., A8 der Stromversorgung SV aktuell gemessenen Spannungswerte mit entsprechenden Referenzspannungswerten verglichen werden. Wird im Prüfschritt 104 z.B. an einem für den zu prüfenden, vorgegebenen Anlagenzustand abgeschalteten Ausgangskanal A1, ..., A8 ein Spannungswert festgestellt, welche den Referenzspannungswert (z.B. 0 Volt) mehr als den vorgegebenen Toleranzbereich überschreitet, so kann diese ebenfalls auf einen Fehler in der Verdrahtung der Anlage bzw. Maschine bzw. des zugehörigen Steuersystems hindeuten. Der entsprechende Lastkreis kann dann im Anzeigeschritt 105 wieder angezeigt werden.

Weiterhin können auch an den im jeweiligen Anlagenzustand ausgeschalteten Ausgangskanälen A1, ..., A8 der Stromversorgung SV aktuell gemessenen Stromwerte im Prüfschritt 104 betrachtet werden, um Verdrahtungs- und/oder Funktionsfehler in der Anlage bzw. den Lastkreisen zu finden.

Bei der in Figur 1 beispielshaft dargestellten Anlage bzw. Maschine würde bei einem Durchlauf der Selbsttestphase, welche zumindest den Messschritt 103, den Prüfschritt 104, den Anzeigeschritt 105 und den Abschlussschritt 106 umfasst, bei den entsprechend vorgegebenen Anlagenzuständen die zwei beispielhaften Verdrahtungsfehler VF1, VF2 festgestellt werden. So würde z.B. im Prüfschritt 104 bei einem vorgegebenen Anlagenzustand, bei welchem zumindest der fünfte Ausgangskanal A5 der Stromversorgung SV eingeschaltet ist, festgestellt werden, dass beispielsweise ein Vergleich der aktuell gemessenen Stromwerte und der gegebenenfalls aktuell gemessenen Spannungswerte mit den entsprechenden Referenzwerten außerhalb des vorgegebenen Toleranzbereichs gelegen ist. Der Vergleich verlässt bzw. überschreitet z.B. betragsmäßig oder prozentuell den Toleranzbereich, da beispielsweise der Motor M bzw. die Lüftereinheit fälschlicherweise nicht vom fünften Ausgangskanal A5 direkt gegen Masse geschaltet, sondern aufgrund des ersten Verdrahtungsfehlers VF1 (z.B. beim Aufbau der Anlage bzw. der Maschine) mit dem sechsten Ausgangskanal A6 verbunden ist und bei einem aktivierten fünften Ausgangskanal A5 der Stromversorgung SV auch ein Strom in den am sechsten Ausgangskanal A6 angeschlossenen Lastkreis eingespeist wird. D.h. es werden im Messschritt 103 beispielsweise am fünften Ausgangskanal A5 der Stromversorgung gegenüber den entsprechenden Referenzstromwerten abweichende (z.B. geringere) Stromwerte gemessen, wodurch der vorgegebene Toleranzbereich vom Vergleich mit den entsprechenden Referenzwerten z.B. betragsmäßig oder prozentuell überschritten werden kann. Weiterhin werden z.B. am sechsten - ausgeschalteten - Ausgangskanal A6 im Messschritt 103 Spannungswerte bzw. Stromwerte gemessen, welche bei einer korrekten Verdrahtung am sechsten Ausgangskanal A6 nicht gemessen würden. Im Prüfschritt 104 können dann ein Herausfallen aus dem bzw. den Toleranzbereichen für diesen Anlagenzustand (d.h. zumindest aktivierter fünfter Ausgangskanal A5 der Stromversorgung SV) festgestellt werden und der am fünften Ausgangskanal A5 der Stromversorgung SV angeschlossene Lastkreis im Anzeigeschritt 105 als fehlerhaft angezeigt werden.

Analog kann bei entsprechenden Anlagenzuständen - z.B. ein Anlagenzustand, in welchem beispielsweise nur der siebente Ausgangskanal A7 der Stromversorgung SV aktiviert ist, und ein Anlagenzustand, in welchem z.B. nur der achte Ausgangskanal A8 der Stromversorgung SV aktiviert ist - in der Selbsttestphase der Anlage bzw. der Maschine erkannt werden, dass hier ein weiterer, zweiter Verdrahtungsfehler VF2 vorliegt, bei welchem die Anschaltung der beiden Sensoreinheiten DS, AS vertauscht wurde. Dieser Verdrahtungsfehler bzw. die entsprechenden Lastkreise können dann ebenfalls im Anzeigeschritt 105 angezeigt werden.

Sollte die gemessenen im Anlagenzustand mit dem siebenten bzw. achten aktivierten Ausgangskanal A7 bzw. A8 gemessenen Stromwerten einen so geringen Unterschied zu den entsprechenden Referenzstromwerten aufweisen, dass der Vergleich innerhalb des bzw. der jeweils vorgegebenen Toleranzbereiche liegt, so wird durch die fälschliche Verkabelung des zweiten Verdrahtungsfehler VF2 die jeweils falsche Lasteinheit bzw. Sensoreinheit DS, AS aktiviert. D.h. das von der akustischen Sensoreinheit AS ausgesandte Funktionssignal wird zeitlich dann für die Steuereinheit SE als Eingangssignal sichtbar, wenn eigentlich der Drucksensor DS aktiviert sein sollte und umgekehrt. Damit kann anhand eine zusätzlichen Auswertung einer zeitlichen Zuordnung von Eingangssignalen zu den jeweiligen Anlagenzuständen im Prüfschritt 104 trotzdem der zweite Verdrahtungsfehler VF2 erkannt werden. Es ist daher von Vorteil Sensoreinheiten DS, AS auszuwählen, welche bereits bei Anliegen einer Versorgungsspannung im jeweils zugehörigen Lastkreis ein Ruhesignal an den entsprechenden Eingang I1, I2 der Steuereinheit SE senden (z.B. 4 bis 20 mA Stromschleifen, aktives High-Signal im Ruhezustand, etc.). Auf diese Weise kann z.B. sehr einfach festgestellt werden, ob die richtige Sensoreinheit, Aktoreinheit, etc. versorgt wird bzw. es kann auch ein etwaiger Kabelbruch in einem Lastkreis damit festgestellt werden.

Weiterhin wird angemerkt, dass das erfindungsgemäße Verfahren nicht nur bei getakteten Stromversorgungen SV eingesetzt werden kann, von welchen einen eingangsseitig angelegte Wechselspannung in eine konstante Ausgangsgleichspannung umgesetzt wird. Das erfindungsgemäße Verfahren kann z.B. auch bei geregelten Spannungsversorgungen für Wechselstrom-Lasteinheiten und damit für einen großen Bereich von Verbrauchern zur Überprüfung einer korrekten Verdrahtung bzw. Funktionsweise dieser Lasteinheiten angewendet werden.

## Patentansprüche

1. Verfahren zum Überprüfen von Lastkreisen eines Steuersystems einer Anlage, wobei das Steuersystem neben zumindest zwei Lastkreisen zumindest eine Steuereinheit (SE) sowie eine getaktete Stromversorgung (SV) umfasst, von welcher die zumindest zwei Lastkreise mit zumindest jeweils einer Lasteinheit über zumindest zwei Ausgangskanäle (A1 bis A8) mit einer Versorgungsspannung und/oder einem Versorgungsstrom versorgt werden, und wobei für eine Ansteuerung der zumindest zwei Ausgangskanäle (A1 bis A8) von der Steuereinheit (SE) Steuersignale zur Verfügung gestellt werden, ***gekennzeichnet durch folgende Schritte:***
- Ermitteln von Referenzstromwerte bei vorgegebenen Spannungswerten der Versorgungsspannung oder Referenzspannungswerte bei vorgegebenen Stromwerten des Versorgungsstroms für jeweils vorgegebene Anlagenzustände, wobei bei einem vorgegebenen Anlagenzustand zumindest ein Ausgangskanal (A1 bis A8) eingeschaltet wird und der jeweils zugehörige Lastkreis von der Versorgungsspannung mit den vorgegebenen Spannungswerten oder vom Versorgungsstrom mit den vorgegebenen Stromwerten versorgt wird (101);
- Abspeichern der für die vorgegebenen Anlagenzustände ermittelten Referenzstromwerte oder der für die vorgegebenen Anlagenzustände ermittelten Referenzspannungswerte (102);
- Messen von aktuellen Stromwerten bei den jeweils vorgegebenen Spannungswerten der Versorgungsspannung oder von aktuellen Spannungswerten bei den jeweils vorgegebenen Stromwerten des Versorgungsstroms am zumindest einen eingeschalteten Ausgangskanal (A1 bis A8) für die jeweils vorgegebenen Anlagenzustände während einer Selbsttestphase (103);
- Prüfen (104), ob bei einem der vorgegebenen Anlagenzustände ein vorgegebener Toleranzbereich bei einem Vergleich der jeweils aktuell gemessenen Stromwerte mit den jeweils entsprechenden, abgespeicherten Referenzstromwerten bei zumindest einem der vorgegebenen Spannungswerte der Versorgungsspannung verlassen wird oder ob bei einem der vorgegebenen Anlagenzustände ein vorgegebener Toleranzbereich bei einem Vergleich der jeweils aktuell gemessenen Spannungswerte mit den jeweils entsprechenden, abgespeicherten Referenzspannungswerten bei zumindest einem der vorgegebenen Stromwerte des Versorgungsstroms verlassen wird;
- und Anzeigen des entsprechenden Lastkreises (105), wenn bei einem der vorgegebenen Anlagenzustände ein Verlassen des vorgegebenen Toleranzbereichs bei zumindest einem der vorgegebenen Spannungswerte der Versorgungsspannung oder bei zumindest einem der borgegebenen Stromwerte des Versorgungsstroms festgestellt wird.

2. Verfahren nach Anspruch 1, ***dadurch gekennzeichnet, dass*** weiterhin für jeweils vorgegebene Anlagenzustände Referenzspannungswerte für zumindest jene Ausgangskanäle (A1 bis A8) ermittelt und abgespeichert werden (101, 102), welche im jeweils vorgegebenen Anlagenzustand ausgeschaltet sind, dass während der Selbsttestphase aktuelle Spannungswerte für die im jeweils aktuellen Anlagenzustand ausgeschalteten Ausgangskanäle (A1 bis A8) gemessen werden (103), dass die gemessenen Spannungswerte mit den Referenzspannungswerten für den jeweiligen Anlagenzustand verglichen werden (104), und dass der jeweilige Lastkreis angezeigt wird (105), bei welchem ein vorgegebener Toleranzbereich beim Vergleich zwischen gemessenen Spannungswerten und jeweils entsprechenden, abgespeicherte Referenzspannungswerten verlassen wird.

3. Verfahren nach einem der Ansprüche 1 bis 2, ***dadurch gekennzeichnet, dass*** weiterhin für jeweils vorgegebene Anlagenzustände Referenzstromwerte für zumindest jene Ausgangskanäle (A1 bis A8) ermittelt und abgespeichert werden (101, 102), welche im jeweils vorgegebenen Anlagenzustand ausgeschaltet sind, dass während der Selbsttestphase aktuelle Stromwerte für jene Ausgangskanäle (A1 bis A8) gemessen werden (103), welche im jeweiligen Anlagenzustand ausgeschaltet sind, dass die gemessenen Stromwerte mit den entsprechenden Referenzstromwerten für den jeweiligen Anlagenzustand verglichen werden (104), und dass der jeweilige Lastkreis angezeigt wird (105), bei welchem ein vorgegebener Toleranzbereich beim Vergleich zwischen gemessenen Stromwerten und jeweils entsprechenden, abgespeicherte Referenzstromwerten verlassen wird.

4. Verfahren nach einem der Ansprüche 1 bis 3, ***dadurch gekennzeichnet, dass*** die Referenzstromwerte und die Referenzspannungswerte für die jeweiligen Anlagenzustände mittels einer Referenzanlage ermittelt werden (101).

5. Verfahren nach einem der Ansprüche 1 bis 3, ***dadurch gekennzeichnet, dass*** die Referenzstromwerte und die Referenzspannungswerte für die jeweiligen Anlagenzustände während einer Inbetriebnahmephase der zu überprüfenden Anlage ermittelt werden (101) oder aus in einem laufenden Betrieb an den jeweiligen Ausgangskanälen gemessenen Stromwerten und Spannungswerten abgeleitet werden (101).

6. Verfahren nach einem der vorangegangenen Ansprüche, ***dadurch gekennzeichnet, dass*** für jeweils vorgegebene Anlagenzustände Referenzwerte von Parameter und/oder Signalen an Eingängen (I1, 12) der Steuereinheit (SE) erfasst (101) und abgespeichert werden (102), dass während der Selbsttestphase für die jeweils vorgegebenen Anlagenzustände aktuelle Werte der Parameter und/oder Signale an den Eingängen (I1, 12) der Steuereinheit (SE) abgefragt (103) und mit den entsprechenden Referenzwerten verglichen werden (104), und dass der jeweilige Lastkreis angezeigt wird (105), bei welchem ein vorgegebener Toleranzbereich beim Vergleich zwischen aktuellen Werten der Parameter und/oder Signale und den jeweils entsprechenden, abgespeicherten Referenzwerten verlassen wird.

7. Verfahren nach einem der vorangegangen Ansprüche, ***dadurch gekennzeichnet, dass*** der vorgegebene Toleranzbereich für den Vergleich der aktuellen Stromwerte mit den entsprechenden Referenzstromwerten und/oder für den Vergleich der aktuellen Spannungswerte mit den entsprechenden Referenzspannungswerten angepasst wird.

8. Verfahren nach einem der vorangegangenen Ansprüche, ***dadurch gekennzeichnet, dass*** die jeweiligen Anlagenzustände und damit die jeweils eingeschalteten und ausgeschalteten Ausgangskanäle (A1 bis A8) sowie die Spannungswerte für die Versorgungsspannung der jeweiligen Ausgangskanäle (A1 bis A8) oder die Stromwerte für den Versorgungsstrom der jeweiligen Ausgangskanäle (A1 bis A8) durch die Steuereinheit (SV) vorgegeben werden.

9. Verfahren nach einem der vorangegangenen Ansprüche, ***dadurch gekennzeichnet, dass*** zwischen Ändern des vorgegebenen Spannungswertes der Versorgungsspannung oder des vorgegebenen Stromwertes des Versorgungsstroms beim jeweils vorgegebenen Anlagenzustand und Ermitteln des aktuellen Strommesswerts für diesen vorgegebenen Spannungswert der Versorgungsspannung eine vorgebbare Wartezeit vorgesehen wird (103).

10. Verfahren nach einem der Ansprüche 1 bis 9, ***dadurch gekennzeichnet, dass*** die vorgegebenen Spannungswerte für die Versorgungsspannung in vorgegebenen Spannungsschritten von einer Ausgangsversorgungsspannung bis zu einer vorgegebenen Nennspannung oder bis zu einer Betriebsgrenze der zumindest einen an den jeweiligen Lastkreis angeschlossenen Lasteinheit angehoben werden (103).

11. Verfahren nach einem der Ansprüche 1 bis 9, ***dadurch gekennzeichnet, dass*** die vorgegebenen Spannungswerte für die Versorgungsspannung in Form einer linearen Spannungsrampe mit vorgebbarer Steigung von einer Ausgangsversorgungsspannung bis zu einer vorgegebenen Nennspannung oder bis zu einer Betriebsgrenze der zumindest einen an den jeweiligen Lastkreis angeschlossenen Lasteinheit angehoben werden (103).

12. Verfahren nach einem der vorangegangenen Ansprüche, ***dadurch gekennzeichnet, dass*** die ermittelten Referenzstromwerte und die ermittelten Referenzspannungswerte in der Steuereinheit (SE) hinterlegt werden (102).

13. Verfahren nach einem der vorangegangenen Ansprüche, ***dadurch gekennzeichnet, dass*** die ermittelten Referenzstromwerte und die ermittelten Referenzspannungswerte an einen Auswerte- und/oder Datenverarbeitungseinheit übermittelt und dort hinterlegt werden (102).

14. Verfahren nach Anspruch 13, ***dadurch gekennzeichnet, dass*** die vorgegebenen Anlagenzustände über die Auswerte- und/oder Datenverarbeitungseinheit ausgewählt werden.

15. Verfahren nach einem der Ansprüche 13 oder 14, ***dadurch gekennzeichnet, dass*** die aktuell gemessenen Stromwerte und/oder Spannungswerte an eine Auswerte- und/oder Datenverarbeitungseinheit weitergeleitet und dort abgespeichert werden (103).
